# EUROPEAN PATENT SPECIFICATION

(11) **EP 3 302 009 B1**
(45) Date of publication and mention of the grant of the patent: **01.03.2023**
(21) Application number: 16191810.7
(22) Date of filing: 30.09.2016
(51) Int. Cl.: H05K 1/14, H05K 7/20, H05K 1/02

(54) **EXTENSION PCB WITH COMMON COOLING SYSTEM**
ERWEITERUNGSLEITERPLATTE MIT GEMEINSAMEM KÜHLSYSTEM
CARTE D'EXTENSION AVEC SYSTÈME DE REFROIDISSEMENT COMMUN

(43) Date of publication of application: 04.04.2018
(73) Proprietor: Napatech A/S, 2860 Søborg (DK)
(72) Inventor: Ek, Claus, DK-3520 Farum (DK)
(74) Representative: Inspicos P/S

(56) References cited:
- DE-A1-102011 085 172
- JP-A- H07 142 834
- US-A1- 2008 035 315
- US-A1- 2010 128 447

## Description

The present invention relates to a manner of extending a printed circuit board or the like having thereon one or more circuits or components, where the extension is the functional or operational attachment of an extension PCB having thereon other or additional circuits or components. Actually, a number of different extension PCBs may be selected between. Having extended the PCB, a cooling structure is connected to the two PCBs to both cool circuits/components as well as increasing the structural strength of the assembly.

Cooling systems may be seen in US/2010/0128447, DE102011085172, JP07142834 and US2008/035315. None of these documents discloses an assembly of a first circuit board, a second circuit board and a cooling structure attached to both the first and second circuit board, the cooling structure preventing the second circuit board from moving, relatively to the first circuit board, wherein the cooling structure is a concave element and wherein the first circuit board and the concave element define, at the edge of the first circuit board and above the first circuit board, a space, the second circuit board having a an element extending away therefrom at the edge of the second circuit board and into the space.

In a first aspect, the invention relates to an assembly according to claim 1.

In this connection, a circuit board may be a printed circuit board (PCB) having, attached to one or more sides thereof, one or more electronic components, such as resistors, capacitors, diodes, coils, chips, ASICs, memory chips, processors, FPGAs, DSPs, transistors, connectors, antennas or the like. Usually, a circuit board is a flat element having a length and a width being at least 5 times or more, such as 10 times or more, larger than a thickness thereof. Usually, a circuit board is a plane element defining a straight plane. Usual circuit boards comprise electric conductors each interconnecting two or more of the components thereof. Such conductors may be provided on or in the circuit boards.

The first and second connectors may be of any type which physically interconnect with each other. Preferably, each of the first and second connectors comprises a number (usually the same number, but this is not a requirement) of electrical conductors which engage in pairs (one from the first connector and one from the second connector) when the connectors are connected. Thus, the electrical conductors and/or components of the first circuit board may communicate, via the connectors, with the electrical conductors and/or components of the second circuit board - and vice versa.

Preferably, the first circuit board comprises a power input and/or one or more further connectors for other elements such as of a computer or server in which the present assembly is provided. The second circuit board may then receive power also via the first/second connectors and/or communicate with such other elements via the first/second connectors and the further connector(s).

Only a single first connector and a single second connector need be provided. Alternatively, multiple first and multiple second connectors may be provided. The first connectors may be identical, of the same type or of different types. Providing multiple first (and/or second) connectors may be chosen for a number of reasons, such as cost, connection strength, available real estate on the circuit boards, electrical requirements. For example, if highfrequency data exchange is required, a more expensive connector may be required. However, this may be so only for some of the connection desired between the two circuit boards, so that a more expensive and a less expensive connector may be used instead of a larger, much more expensive connector.

One single first connector may be connected with multiple second connectors or vice versa.

The first and second connectors are provided at respective edges of the first and second circuit boards. In this respect, an edge is a portion of a surface of a circuit board deviating from a main surface of a circuit board. Usually, a circuit board is a flat element having two opposing main surfaces and an edge around its periphery.

The connectors may extend over the edge(s) if desired or may be connected at positions of the circuit boards away from the edges. Preferably each connector has a connecting portion which is configured to engage the other of the connector pair (first and second connector). Often, a connector pair (a first and a second connector) is attached in a male-female fashion, where one connector has a portion introduced into the other connector. Often, the direction of translation of one connector in relation to the other connector is denoted a longitudinal axis. Usually, this longitudinal axis is in a plane of one or both of the circuit boards. Usually the direction is, seen from one of the connectors, toward and away from the other connector and the circuit board to which it is connected.

If multiple first and second connectors are provided, the directions of translation required to engage each pair preferably are parallel, so that this translation of one circuit board in relation to the other may engage or disengage all pairs of connectors.

Thus, the connecting portions preferably are provided at the respective edges. Naturally, the connecting portion, and thus the connector, of one of the connectors may extend beyond the edge and thus outside, in a projection on to a plane of the pertaining circuit board, in order for it to be able to engage the other of the connector pair, such as if the connecting portion of the other connector is provided at the edge or inside the edge of that circuit board, in a projection on to a plane of that circuit board.

In a preferred embodiment, the first and second circuit boards, at the respective edges thereof, abut or at least are at least substantially parallel, when the first and second connectors are interconnected.

A cooling structure is provided. Preferably, the cooling structure is monolithic or has a single element, such as a plate or housing, to which each of the first and second circuit boards is attached. This attachment may, naturally, be permanent, such as by gluing, welding, soldering or the like, but it is preferably detachable, such as by using screws, clamps or the like.

The cooling structure extends over at least a portion of both the first and second circuit boards.

As described above, the first and second connectors usually are engageable and disengageable by translating one in relation to the other along a predetermined direction. Preferably, the cooling structure is at least substantially non-extendable along that direction, when attached to the circuit boards. Thus, the cooling structure may prevent such detachment.

In this context, "non-extendable" may mean that the cooling structure is not extendable in that direction to a degree where the connectors can disengage - at least due to a pulling force of 1N, such as a pulling force of 3N, such a as a pulling force of 5N, such as a pulling force of 7N in that direction applied to the first and second circuit boards or connectors.

The cooling structure is directly or indirectly attached to the first and second circuit boards. This attachment may, as described above, be detachable. In a preferred embodiment, the attachment is a localized attachment where the cooling structure is fastened to each of the first and second circuit boards at one or more positions thereof. In one embodiment, each of the first and second circuit boards has localized elements, such as holes or protruding elements, to which the cooling structure is fastened.

Then, the cooling structure preferably extends, in a plane of one or both circuit boards, over at least a portion of each of the first and second circuit boards. This portion preferably comprises components of the first and second circuit boards which are desired cooled. Then, the local fastening positions, if used, may be provided within such portions of the first and second circuit boards.

In one embodiment, the first and second circuit boards each comprises electrical components connected thereto, the electrical components facing the cooling structure. In this manner, such components may be cooled. Cooling may be performed in many manners. In one manner, components may be thermally connected to the cooling element, such as by the components abutting the cooling element or are contacting the cooling element via e.g. a thermally conductive element, such as a paste. Cooling may also take place simply by providing a sufficiently small distance between the component and the cooling element. In an embodiment described below, cooling may be performed by driving air through an enclosure formed by the cooling element and the circuit boards, whereby the components in the enclosure are cooled.

In one embodiment:
- the first circuit board extends within a first plane,
- the second circuit board extends within the first plane and
- the cooling structure extends within a second plane at least substantially parallel to the first plane,
the cooling structure being attached to the first and second circuit boards to prevent the second circuit board from moving, relatively to the first circuit board in the first plane.

Usually, as mentioned above, a circuit board is a plane, flat element having two major, parallel surfaces each of which defines a plane. A centre of the circuit board would also define a plane parallel thereto.

Thus, when the first and second circuit boards lie in the same plane, they will be parallel and co-extending. Then, the circuit boards may define there between an opening or a slot, but they may abut to at least substantially form a single circuit board or a surface which may be used for guiding air, as will be described below.

When the cooling structure is parallel to the plane, a regular shape of the assembly is obtained. Also, when the cooling structure does not lie in the first plane but at a distance therefrom, it will give stiffness to the assembly. Thus, it may be desired that the cooling structure in itself is rather stiff, non-bendable, non-compressible or non-extendable. In one situation, the cooling structure may comprise a part, extending in the second plane and having a thickness of at least ½mm, which part is made of a hard plastic material, a metal or the like. Additional stiffness may be obtained by providing a cooling structure extending out of the second plane, such as with elements extending at an angle to the first plane as well as in a direction from the second circuit board toward the first circuit board. Thus, a U-shape or the like may be obtained where the bottom of the U lies in the second plane and where the sides extend at an angle thereto.

In one situation, the cooling structure comprises an upper surface and a lower surface, the lower surface being thermally connected to one or more electric components attached to the first and second circuit boards, the upper surface having heat dissipating elements.

In this respect, thermal connection may be a direct, physical contact or a contact via a thermally conducting element, such as thermally conducting element, such as a spring or a paste. Usually, the components connected to the cooling structure are the ones which need the most cooling so as to not reach a threshold temperature and/or which generate the most heat. Other components may be more heat tolerant or generate less heat.

Other of the components which are provided between the circuit boards and the lower surface may be cooled due to the lower surface cooling air/gas in this space.

When the cooling structure is thermally connected to some components and may cool other components via the air between the cooling structure and those components, the cooling structure may be suited to provide sufficient cooling without using e.g. a fan for creating an airflow to transport heat away therefrom. One manner of increasing the cooling of a cooling structure is to provide heat dissipating elements, such as cooling fins, on the other (upper) surface thereof.

The cooling structure is a concave element configured to form, with the first and second circuit boards, an enclosure, the assembly comprising an air forcing element, such as a fan, for forcing air into or out of the enclosure. In this respect, the concave element has an outer portion extending toward the circuit boards and a central portion, which may extend parallel to the circuit boards. The concave element preferably is made of a stiff material. Usually, the air forcing element is provided in or at an opening in the concave element to allow the air forcing element to transport air from outside to inside of the enclosure or in the opposite direction.

In this situation, the cooling structure preferably has a periphery, when projected on to a plane of e.g. the first circuit board, corresponding to or falling inside a combined outer periphery of the first and second circuit boards in that plane. Also, preferably, the cooling structure, for at least 50%, such as at least 60%, such as at least 70%, such as at least 80% of its periphery, abuts or is no more than 1mm or nor more than 2mm from the first and/or second circuit boards in order to form a sufficiently sealed enclosure efficiently guiding the air.

Often, it is desired to allow air to escape or enter the enclosure at predetermined portions of an interface between the circuit board(s) and the concave element. A further alternative solution would be to provide openings in the circuit board(s) and/or concave element for allowing air to escape or enter the enclosure.

The first circuit board and the concave element define there between, at the edge of the first circuit board, a space, the second circuit board having an element extending away from the second circuit board at the edge of the second circuit board and into the space. This is especially interesting in the below situation where the first circuit board is to be used also as a stand-alone circuit board and thus is prepared for a second cooling structure forming a cavity and having an air forcing element positioned, in that situation, in the space. Air forcing elements normally extend from the housing and toward the circuit board in order to not exceed a defined maximum thickness of the assembly, in a plane perpendicular to the first circuit board, whereby the concave element is usually defined to extend as far away from the circuit board as possible to allow passage of air there through and to allow space for as many and as high components as possible. Thus, the air forcing element will define a limit to how far components may extend from the first circuit board toward the air forcing element when the first circuit board is used as a stand-alone board.

When this board is then expanded by the second circuit board, the air forcing element preferably is positioned in the concave element and above the second circuit board. Then, the space otherwise reserved for the air forcing element above the first circuit element is now vacant. The second circuit board thus may comprise an element extending from the second circuit board and into this space. This element may extend above or between the connector(s) and further over a portion of the first circuit board if desired.

In this context, where air forcing elements are used, it is generally desired to position the air forcing element at one end of an elongate channel (the enclosure or below channel), where at the other end of the channel air is allowed to enter or escape the channel. In this manner, optimal cooling is obtained. Usually, the longitudinal axis of this channel extends through a center of the first circuit board and a center of the second circuit board. Thus, the air forcing element may be provided at either end. Usually, when the assembly is fastened to a computer, such as in the form of a PCI card in a server, the first circuit board will have the connectors required for connecting to the PCI slot. Thus, usually, the first circuit board is positioned closer to the chassis of the server than the second circuit board. Thus, it is preferred to provide the air forcing element over the second circuit board and operate the air forcing element to force air into the channel/enclosure, where heated air is then allowed to exit the channel/enclosure at the other end - preferably at an edge of the first circuit board opposite to the edge at which the first connector(s) is/are provided, so that air may be output to outside of the computer/server.

According to the method of the invention,the assembly comprises a second cooling structure configured to be attached only to the first circuit board and thermally connect only to electrical components on the first circuit board. Thus, the first circuit board may be used as a stand-alone board not connected to a second circuit board.

Preferably, the second cooling structure extends over at least a portion of the first circuit board, seen in a plane defined by the first circuit board. Naturally, if localized fastening elements are provided in the first circuit board, c.f. above, for fastening the first cooling structure to the first circuit board, such fastening elements may also be used for fastening the second cooling structure to the first circuit board.

The second cooling structure may be as that described above suitable for passive cooling.

Preferably, however, the second cooling structure is a concave element configured to, together with the first circuit board, form a channel, an air forcing element provided at least partly in the cavity for forcing air into or out of the channel. Thus, the above description and advantages relating to the above-described concave element are relevant also in this situation.

An advantage of the present invention may be seen when the assembly further comprises a third circuit board, the second circuit board extending within a predetermined plane and having a first cross section within that plane, the third circuit board extending within another plane and having the first cross section within that plane. Then, the second and third circuit boards may be interchanged and both fastened to or form an enclosure with the cooling structure. Naturally, if local fastening elements are provided in the second circuit board, the third circuit board preferably has the same type(s) of fastening elements in at least one of the positions at which the second circuit board has fastening elements. Then, also the third circuit board may be attached to the first cooling structure.

The first cooling structure may have a plurality of localized fastening means for fastening to the local fastening elements of the circuit boards. Naturally, not all fastening means or fastening elements need be used all the time. Thus, the second and third circuit boards may attach to the first cooling structure using different (in position) fastening elements, or some fastening elements may be the same and others not. Naturally, fully differently positioned fastening elements may be used.

In addition, preferably the second circuit board has one or more third connectors at an edge thereof, at least one of the third connectors being configured to engage a first connector of the first circuit board. Again, there is no requirement that the second and third circuit boards have the same positions and types of connectors. The first circuit element may have connectors or parts thereof which are not connected to a second connector but which is connected to a third connector.

In this manner, the first circuit board may be expanded with a number of different circuit boards which may have different types of circuits or capabilities. Naturally, fourth, fifth, etc, circuit boards may be designed with even further circuit types and/or capabilities.

Extension circuit boards may have different types of circuits, such as processors or processing capability, connectors/antennas for different types of communication, storage capability or the like.

A second aspect of the invention relates to a method according to claim 8.

As described above, the first cooling structure may be for passive or active cooling.

The above considerations relating to the circuit boards, cooling, fastening and the like are equally applicable here. Thus, the fastening step may comprise fastening the second circuit board to a first set of fastening means of the first cooling structure. Then, the second circuit board may be disengaged and a third circuit board attached using a second set of fastening means.

Preferred embodiments of the invention will now be described with reference to the drawings, wherein:
- figure 1 illustrates a first example not according to the invention with an extended board and a substitute extension board,
- figure 2 illustrates a second example not according to the invention for cooling an extended board,
- figure 3 illustrate cooling of a non-extended boards of the first and second examples not according to the invention, and
- figure 4 illustrates an embodiment of the assembly according to the invention, comprising a second circuit board utilizing space over the first circuit board.

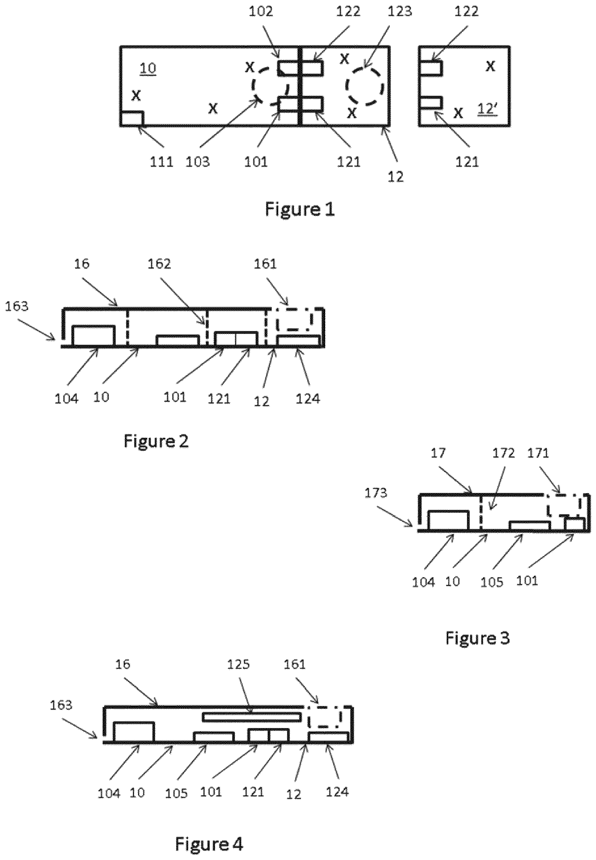

In figure 1, an example of an extended circuit board 10 is seen. The circuit board 10 has connectors 101 and 102 to which connectors 121 and 122 of circuit board 12 may be connected, so that the circuit board 10 is extended. Now, circuits or other electronics of circuit boards 10 and 12 may communicate via the connectors.

Any number of connectors may be used for interconnecting the boards.

The circuit board 12 may be replaced by another circuit board 12' also having connectors 121 and 122 or, only the connector 121. The boards 12 and 12' may have different circuits or different capabilities, so that the board 10 may be extended with different capabilities depending on what is desired or required.

The board 10 may be a multi-purpose board having other connectors 111 for e.g. receiving data or data packets and analyzing these. The boards 12 and 12' may then have additional processors for additional analysis, additional storage, input/output capabilities (connectors, PHYs, MACs or the like) for different types of communication or equipment, or the like. Thus, the capability of the board 10 may be adapted by attaching a board 12/12' with the desired capabilities.

Usually, the connectors are configured to attach to each other by translation the plane of the boards and toward and into each other. Thus, the connectors may prevent translation of the boards in a direction perpendicular to the plane of the connectors.

However, it is desired to both prevent the connectors from disengaging and additionally to bring more stiffness to the combined boards. In addition, electronics often need cooling. Thus, a cooling element 16 is provided (figure 2) which extends over at least a portion of both boards 10 and 12 and is fastened thereto using screws or the like 152.

Electronic components may be attached to one of or both of boards 10 and 12 on both sides thereof. It may be desired to provide a single cooling element 16 and to provide at least those components requiring cooling or the most cooling on the surface facing the cooling element 16.

In figure 2 where a cooling housing 16 is fastened to the boards 10/12 with screws 162 or the like. A fan 161 is provided forcing air into or out of the space between the housing 16 and the boards 10/12. A slot or opening 163 may be provided at an opposite end of the space than that of the fan 161 for allowing air to enter or exit the space.

The cooling is forced or active. All components provided in the space are cooled by the airflow. The direction of the airflow may be selected appropriately, as the components the closest to the entrance (fan or slot) of the cooling air are cooled most efficiently.

In general, the cooling element or housing 16 have the effect of facilitating the cooling as well as providing stiffness to the board assembly of boards 10 and 12. As mentioned, the connectors 101/121 usually will be disconnected by relative translation in the plane of the boards. The attachment of the housing/element thus may prevent such relative translation by their stiffness and their attachment to the boards. In addition, the attachment of a parallel element extending over at least a portion of both boards brings about an increased stiffness of the overall assembly so that the assembly may safely be handled as a unit when e.g. being mounted in a server or the like.

In figure 3, the board 10 is illustrated again as a stand-alone element now with active cooling via a fan 171 and a housing 17. As described above, the housing 17 may be attached to the board 10 and an opening/slot 173 may be provided. In this situation, the connectors 101/102 are not required, and they may be provided in the enclosure to prevent air from escaping close to the fan 171.

In this latter situation, it is seen that the fan 171 puts dimensional requirements to the component(s) 105 positioned between the fan and the board 10. This is especially interesting when the board 10 is later expanded, whereby the position of the fan may be altered. Naturally, the fan position may be maintained even in expanded assemblies, where the housing at the expansion board 12/12' would then preferably also have a slot/opening for allowing air to enter or escape the space.

However, it is desired to have the fan at an end of the space. In figure 1, the fan position 103 illustrates the position of the fan in a stand-alone embodiment where the board 10 is not expanded and fan position 123 is preferably used in an expanded situation.

However, in this situation, the space reserved for the fan in the stand-alone situation may then be utilized in the expanded situation. Thus, according to the invention, the expansion board 12/12' may comprise an element, such as a component or a cooling element 125 which expands into the space above the board 10. This is illustrated in figure 4.

Reverting to figure 1, a number of positions where the circuit boards 10, 12 and 12' may be attached to the cooling structures are marked by "x". It is seen that the boards 12 and 12" have different positions. Thus, the cooling structure 14/16 may have different positions for fastening boards, and the positions may be used which are the most suitable for each board.

## Claims

1. An assembly comprising:
- a first circuit board (10) comprising one or more first connectors (101, 102) at an edge thereof,
- a second circuit board (12) comprising one or more second connectors (121, 122) at an edge thereof, the first and second connectors being adapted to connect to each other,
wherein the assembly further comprises a cooling structure (16) attached to both the first and second circuit boards and preventing the second circuit board from moving, relatively to the first circuit board, so as to disconnect the first and second connectors, wherein:
- the cooling structure is a concave element configured to form, with the first and second circuit boards, an enclosure, the assembly comprising an air forcing element (161) for forcing air into or out of the enclosure and
- the first circuit board and the concave element define, at the edge of the first circuit board and above the first circuit board, a space (103), the second circuit board having an element (125) extending away therefrom at the edge of the second circuit board and into the space.

2. An assembly according to claim 1, wherein the first and second circuit boards each comprises electrical components (124) connected thereto, the electrical components facing the cooling structure.

3. An assembly according to claim 1 or 2, wherein:
- the first circuit board extends within a first plane,
- the second circuit board extends within the first plane and
- the cooling structure extends within a second plane at least substantially parallel to the first plane,
the cooling structure being attached to the first and second circuit boards to prevent the second circuit board from moving, relatively to the first circuit board in the first plane.

4. An assembly according to any of claims 1-3, wherein the cooling structure comprises an upper surface and a lower surface, the lower surface being thermally connected to one or more electric components attached to the first and second circuit boards, the upper surface having heat dissipating elements.

5. An assembly according to any of the preceding claims, further comprising a third circuit board (12'), the second circuit board extending within a plane and having a first cross section within the plane, the third circuit board extending within another plane and having the first cross section within that plane.

6. A method of extending a first circuit board (10), the method comprising:
- providing a first circuit board (10) comprising one or more first connectors (101, 102) at an edge thereof, the first circuit board (10) being attached to a second cooling structure (17),
- removing the second cooling structure (17),
- providing a second circuit board (12) comprising one or more second connectors (121,122) at an edge thereof, the first and second connectors being adapted to connect to each other, and
- attaching a first cooling structure (16) to both the first and second circuit boards to prevent the second circuit board (12) from moving, relatively to the first circuit board (10), so as to disconnect the first and second connectors, wherein:
- the first cooling structure (16) is a concave element configured to form, with the first and second circuit boards, an enclosure, the assembly comprising an air forcing element (161) for forcing air into or out of the enclosure and
- the first circuit board (10) and the concave element define, at the edge of the first circuit board (10) and above the first circuit board (10), a space (103), the second circuit board (12) having an element (125) extending away therefrom at the edge of the second circuit board (12) and into the space (103).

7. A method according to claim 6, wherein the second cooling structure (17) is configured to be attached only to the first circuit board and thermally connected only to electrical components (101, 105, 104) on the first circuit board.

8. A method according to claim 6 or 7, wherein the second cooling structure is a concave element configured to, together with the first circuit board, form a channel, an air forcing element (171) provided at least partly in the cavity for forcing air into or out of the channel.

## Patentansprüche

1. Baugruppe, die umfasst:
- eine erste Leiterplatte (10), die einen oder mehrere erste Verbinder (101, 102) an einem Rand davon umfasst,
- eine zweite Leiterplatte (12), die einen oder mehrere zweite Verbinder (121, 122) an einem Rand davon umfasst, wobei die ersten und die zweiten Verbinder so ausgelegt sind, dass sie sich miteinander verbinden,
wobei die Baugruppe ferner eine Kühlstruktur (16) umfasst, die an sowohl der ersten als auch der zweiten Leiterplatte angebracht ist und die verhindert, dass sich die zweite Leiterplatte relativ zu der ersten Leiterplatte bewegt, um die ersten und die zweiten Verbinder zu lösen, wobei:
- die Kühlstruktur ein konkaves Element ist, das so konfiguriert ist, dass es mit der ersten und der zweiten Leiterplatte eine Umschließung bildet, wobei die Baugruppe ein Lufttreibelement (161) zum Treiben von Luft in die Umschließung oder aus dieser heraus umfasst, und
- die erste Leiterplatte und das konkave Element an dem Rand der ersten Leiterplatte und über der ersten Leiterplatte einen Raum (103) definieren, wobei die zweite Leiterplatte ein Element (125) aufweist, das sich an dem Rand der zweiten Leiterplatte weg davon und in den Raum erstreckt.

2. Baugruppe nach Anspruch 1, wobei die erste und die zweite Leiterplatte jeweils damit verbundene elektrische Bauteile (124) umfassen, wobei die elektrischen Bauteile der Kühlstruktur zugewandt sind.

3. Baugruppe nach Anspruch 1 oder 2, wobei:
- sich die erste Leiterplatte innerhalb einer ersten Ebene erstreckt,
- sich die zweite Leiterplatte innerhalb der ersten Ebene erstreckt, und
- sich die Kühlstruktur innerhalb einer zweiten Ebene zumindest im Wesentlichen parallel zu der ersten Ebene erstreckt,
wobei die Kühlstruktur an der ersten und der zweiten Leiterplatte angebracht ist, um zu verhindern, dass sich die zweite Leiterplatte relativ zu der ersten Leiterplatte in der ersten Ebene bewegt.

4. Baugruppe nach einem der Ansprüche 1 bis 3, wobei die Kühlstruktur eine obere Oberfläche und eine untere Oberfläche umfasst, wobei die untere Oberfläche mit einem oder mehreren elektrischen Bauteilen wärmeverbunden ist, die an der ersten und der zweiten Leiterplatte angebracht sind, wobei die obere Oberfläche wärmeableitende Elemente aufweist.

5. Baugruppe nach einem der vorstehenden Ansprüche, die ferner eine dritte Leiterplatte (12') umfasst, wobei sich die zweite Leiterplatte innerhalb einer Ebene erstreckt und einen ersten Querschnitt innerhalb der Ebene aufweist, wobei sich die dritte Leiterplatte innerhalb einer anderen Eben erstreckt und den ersten Querschnitt innerhalb dieser Ebene aufweist.

6. Verfahren zum Erweitern einer ersten Leiterplatte (10), wobei das Verfahren umfasst:
- Bereitstellen einer ersten Leiterplatte (10), die einen oder mehrere erste Verbinder (101, 102) an einem Rand davon umfasst, wobei die erste Leiterplatte (10) an einer zweiten Kühlstruktur (17) angebracht ist,
- Entfernen der zweiten Kühlstruktur (17),
- Bereitstellen einer zweiten Leiterplatte (12), die einen oder mehrere zweite Verbinder (121, 122) an einem Rand davon umfasst, wobei die ersten und die zweiten Verbinder so ausgelegt sind, dass sie sich miteinander verbinden, und
- Anbringen einer ersten Kühlstruktur (16) an sowohl der ersten als auch der zweiten Leiterplatte, um zu verhindern, dass sich die zweite Leiterplatte (12) relativ zu der ersten Leiterplatte (10) bewegt, um die ersten und die zweiten Verbinder zu lösen, wobei:
- die erste Kühlstruktur (16) ein konkaves Element ist, das so konfiguriert ist, dass es mit der ersten und der zweiten Leiterplatte eine Umschließung bildet, wobei die Baugruppe ein Lufttreibelement (161) zum Treiben von Luft in die Umschließung oder aus dieser heraus umfasst, und
- die erste Leiterplatte (10) und das konkave Element an dem Rand der ersten Leiterplatte (10) und über der ersten Leiterplatte (10) einen Raum (103) definieren, wobei die zweite Leiterplatte (12) ein Element (125) aufweist, das sich an dem Rand der zweiten Leiterplatte (12) weg davon und in den Raum (103) erstreckt.

7. Verfahren nach Anspruch 6, wobei die zweite Kühlstruktur (17) so konfiguriert ist, dass sie nur an der ersten Leiterplatte angebracht wird und nur mit elektrischen Bauteilen (101, 105, 104) auf der ersten Leiterplatte wärmeverbunden wird.

8. Verfahren nach Anspruch 6 oder 7, wobei die zweite Kühlstruktur ein konkaves Element ist, das so konfiguriert ist, dass es gemeinsam mit der ersten Leiterplatte einen Kanal bildet, ein Lufttreibelement (171), das zumindest teilweise in dem Hohlraum bereitgestellt ist, um Luft in den Kanal oder aus diesem heraus zu treiben.

## Revendications

1. Ensemble comprenant :
- une première carte de circuit imprimé (10) comprenant un ou plusieurs premiers connecteurs (101, 102) sur un bord de celle-ci,
- une deuxième carte de circuit imprimé (12) comprenant un ou plusieurs seconds connecteurs (121, 122) sur un bord de celle-ci, les premier et second connecteurs étant conçus pour se connecter l'un à l'autre,
dans lequel l'ensemble comprend en outre une structure de refroidissement (16) fixée à la fois aux première et deuxième cartes de circuit imprimé et empêchant la deuxième carte de circuit imprimé de se déplacer, par rapport à la première carte de circuit imprimé, de manière à déconnecter les premier et second connecteurs, dans lequel :
- la structure de refroidissement est un élément concave configuré pour former, avec les première et deuxième cartes de circuit imprimé, une enceinte, l'ensemble comprenant un élément de forçage d'air (161) pour forcer de l'air dans ou hors de l'enceinte et
- la première carte de circuit imprimé et l'élément concave définissent, sur le bord de la première carte de circuit imprimé et au-dessus de la première carte de circuit imprimé, un espace (103), la deuxième carte de circuit imprimé ayant un élément (125) s'étendant à partir de celle-ci sur le bord de la deuxième carte de circuit imprimé et dans l'espace.

2. Ensemble selon la revendication 1, dans lequel les première et deuxième cartes de circuit imprimé comprennent chacune des composants électriques (124) connectés à celles-ci, les composants électriques faisant face à la structure de refroidissement.

3. Ensemble selon la revendication 1 ou 2, dans lequel :
- la première carte de circuit imprimé s'étend dans un premier plan,
- la deuxième carte de circuit imprimé s'étend dans le premier plan et
- la structure de refroidissement s'étend dans un second plan au moins sensiblement parallèle au premier plan,
la structure de refroidissement étant fixée aux première et deuxième cartes de circuit imprimé pour empêcher la deuxième carte de circuit imprimé de se déplacer, par rapport à la première carte de circuit imprimé dans le premier plan.

4. Ensemble selon l'une quelconque des revendications 1 à 3, dans lequel la structure de refroidissement comprend une surface supérieure et une surface inférieure, la surface inférieure étant thermiquement connectée à un ou plusieurs composants électriques fixés aux première et seconde cartes de circuit imprimé, la surface supérieure ayant des éléments dissipateurs de chaleur.

5. Ensemble selon l'une quelconque des revendications précédentes, comprenant en outre une troisième carte de circuit imprimé (12'), la deuxième carte de circuit imprimé s'étendant dans un plan et ayant une première section transversale dans le plan, la troisième carte de circuit imprimé s'étendant dans un autre plan et ayant la première section transversale dans ce plan.

6. Procédé d'extension d'une première carte de circuit imprimé (10), le procédé comprenant :
- la fourniture d'une première carte de circuit imprimé (10) comprenant un ou plusieurs premiers connecteurs (101, 102) sur un bord de celle-ci, la première carte de circuit imprimé (10) étant fixée à une seconde structure de refroidissement (17),
- le retrait de la seconde structure de refroidissement (17),
- la fourniture d'une deuxième carte de circuit imprimé (12) comprenant un ou plusieurs seconds connecteurs (121, 122) sur un bord de celle-ci, les premier et second connecteurs étant conçus pour se connecter l'un à l'autre, et
- la fixation d'une première structure de refroidissement (16) à la fois aux première et deuxième cartes de circuit imprimé pour empêcher la deuxième carte de circuit imprimé (12) de se déplacer, par rapport à la première carte de circuit imprimé (10), de manière à déconnecter les premier et second connecteurs, dans lequel :
- la première structure de refroidissement (16) est un élément concave configuré pour former, avec les première et deuxième cartes de circuit imprimé, une enceinte, l'ensemble comprenant un élément de forçage d'air (161) pour forcer de l'air dans ou hors de l'enceinte et
- la première carte de circuit imprimé (10) et l'élément concave définissent, sur le bord de la première carte de circuit imprimé (10) et au-dessus de la première carte de circuit imprimé (10), un espace (103), la deuxième carte de circuit imprimé (12) ayant un élément (125) s'étendant à partir de celle-ci sur le bord de la deuxième carte de circuit imprimé (12) et dans l'espace (103).

7. Procédé selon la revendication 6, dans lequel la seconde structure de refroidissement (17) est configurée pour être fixée uniquement à la première carte de circuit imprimé et connectée thermiquement uniquement aux composants électriques (101, 105, 104) sur la première carte de circuit imprimé.

8. Procédé selon la revendication 6 ou 7, dans lequel la seconde structure de refroidissement est un élément concave configuré pour, avec la première carte de circuit imprimé, former un canal, un élément de forçage d'air (171) étant prévu au moins partiellement dans la cavité pour forcer de l'air dans ou hors du canal.
